Europäisches Patentamt

European Patent Office

Office européen des brevets

(19)

(11) **EP 0 496 447 B1**

(12) **EUROPÄISCHE PATENTSCHRIFT**

(45) Veröffentlichungstag und Bekanntmachung des
Hinweises auf die Patenterteilung:
**23.07.1997   Patentblatt 1997/30**

(51) Int Cl.$^6$: **G01R 33/48**

(21) Anmeldenummer: **92200096.3**

(22) Anmeldetag: **15.01.1992**

(54) **Kernresonanzspektroskopieverfahren und Anordnung zur Durchführung des Verfahrens**

NMR spectroscopy method and apparatus for carrying out the method

Procédé de spectroscopie RMN et dispositif de mise en oeuvre du procédé

(84) Benannte Vertragsstaaten:
**DE FR GB NL**

(30) Priorität: **24.01.1991  DE 4102023**

(43) Veröffentlichungstag der Anmeldung:
**29.07.1992   Patentblatt 1992/31**

(73) Patentinhaber:
• **Philips Patentverwaltung GmbH**
**22335 Hamburg (DE)**
Benannte Vertragsstaaten:
**DE**
• **Philips Electronics N.V.**
**5621 BA Eindhoven (NL)**
Benannte Vertragsstaaten:
**FR GB NL**

(72) Erfinder:
• **McKinnon, Graeme, Dr.**
**CH-8053 Zürich (CH)**
• **Bösiger, Peter, Dr. Priv.-Doz.**
**CH-5400 Ennetbaden (CH)**

(74) Vertreter: **Hartmann, Heinrich, Dipl.-Ing. et al**
**Philips Patentverwaltung GmbH,**
**Röntgenstrasse 24**
**22335 Hamburg (DE)**

(56) Entgegenhaltungen:
**EP-A- 404 248**           **EP-A- 0 370 333**
**EP-A- 0 412 602**         **WO-A-90/13827**
**US-A- 4 871 967**

• **JOURNAL OF MAGNETIC RESONANCE. Bd. 86,
Nr. 1, 1. Januar 1990, ORLANDO, MN US Seiten
191 - 198; L.A. TRIMBLE ET AL.: 'LACTATE
EDITING BY MEANS OF SELECTIVE-PULSE
FILTERING OF BOTH ZERO-AND
DOUBLE-QUANTUM COHERENCE SIGNALS'**
• **Society of Magnetic Resonance in Medicine.
Seventh Annual Meeting and Exhibition, 20-26
August 1988, San Francisco, CA, US D.M.
FREEMAN et al.: "Monitoring steady state tumor
lactic acid levels in vivo in different tumor cell
lines using two-dimensional double quantum
coherence transfer spectroscopy" page 212**

**Beschreibung**

Die Erfindung betrifft ein Kernresonanzspektroskopieverfahren, bei dem in Anwesenheit eines homogenen stationären Magnetfeldes auf einen Untersuchungsbereich eine Vielzahl von Sequenzen einwirkt, von denen jede wenigstens drei vorzugsweise als 90°-Impulse ausgebildete Hochfrequenzimpulse umfaßt, wobei zwischen dem zweiten und dem dritten Hochfrequenzimpuls sowie nach dem dritten Hochfrequenzimpuls magnetische Gradientenfelder mit solcher Amplitude und Dauer wirksam werden, daß nach dem dritten Hochfrequenzimpuls auftretende Kernresonanzsignale nur durch Doppelquantenkohärenz bestimmt sind. Außerdem betrifft die Erfindung eine Anordnung zur Durchführung dieses Verfahrens.

Ein derartiges Verfahren ist aus den SMRM Abstracts (San Francisco, 212 (1988) und aus Chem. Phys. Lett., 69 (1980), S. 567-570 bekannt. Bei dem bekannten Verfahren wird vor und nach dem letzten Hochfrequenzimpuls ein magnetisches Gradientenfeld ein- und ausgeschaltet. Das zeitliche Integral über dieses Feld nach dem letzten Impuls ist dabei gerade doppelt so groß wie das entsprechende Integral vor diesem Impuls. Dadurch wird erreicht, daß nur Doppelquantenkohärenzen Einfluß auf das Kernresonanzsignal haben. Einfachquantenkohärenzen, insbesondere aber die Signale, die von an Wasser gebundenen Protonen herrühren, werden dabei stark unterdrückt.

In der genannten SMRM-Veröffentlichung wird dieses Verfahren eingesetzt, um die Konzentration von Milchsäure bzw. Laktat unabhängig von der Konzentration von Fett bzw. Lipiden zu bestimmen. Die Larmorfrequenzen von an Fett und an Milchsäure gebundenen Protonen liegen sehr dicht beieinander. Um diese beiden Komponenten gleichwohl voneinander trennen zu können, wird bei dem bekannten Verfahren ein zweidimensionales Frequenzspektrum erzeugt. Dazu wird die sogenannte Evolutionszeit zwischen dem zweiten und dem dritten Hochfrequenzimpuls in Stufen geändert, und aus den dabei gewonnenen Kernresonanzsignalen wird durch eine zweidimensionale Fouriertransformation ein zweidimensionales Frequenzspektrum gewonnen, in dem sich Fett- und Milchsäure gut voneinander trennen lassen.

Zweidimensionale Frequenzspektren erfordern sehr lange Gesamtmeßzeiten und sind gegenüber Bewegungen im Untersuchungsbereich empfindlich. Es wäre daher erstrebenswert, in einem eindimensionalen Frequenzspektrum die Milchsäurekonzentration unabhängig von der Fettkonzentration bestimmen zu können. Dies wird dadurch erschwert, daß die eine Frequenzkomponente von an Milchsäure gebundenen Protonen in unmittelbarer Nähe der Larmorfrequenz von an Wasser gebundenen Protonen liegt und daß die andere Frequenzkomponente von Milchsäure einer Fettkomponente unmittelbar benachbart ist, die auch im Doppelquantenspektrum enthalten ist.

Aufgabe der vorliegenden Erfindung ist es, ein Verfahren der eingangs genannten Art so auszugestalten, daß einerseits die Lipidkomponente, die im Frequenzspektrum praktisch mit der Laktatkomponente zusammenfällt, wesentlich reduziert wird und daß andererseits gleichzeitig die räumliche Verteilung der Kernmagnetisierung in mindestens einer Dimension bestimmbar ist.

Diese Aufgabe wird erfindungsgemäß dadurch gelöst, daß zwischen den drei Hochfrequenzimpulsen wenigstens ein magnetisches Gradientenfeld wirksam ist und das zeitliche Integral über wenigstens eines dieser Gradientenfelder bei der Wiederholung der Sequenzen variiert wird, und daß zur Reduzierung der Lipidkomponente im Bereich der Laktatkomponente der zweite Hochfrequenzimpuls derart frequenzselektiv ist, daß er die Kernmagnetisierung der mit der Laktatkomponente gekoppelten Komponente anregt, aber nicht die Kernmagnetisierung der mit der Lipidkomponente gekoppelten Komponente.

Die Erfindung basiert auf folgenden Überlegungen. Bei einer Sequenz nach dem eingangs erwähnten Verfahren können durch den zweiten Hochfrequenzimpuls Doppelquantenübergänge angeregt werden, insbesondere wenn er einen definierten zeitlichen Abstand von dem ersten Hochfrequenzimpuls hat (1/2J) oder ein ungeradzahliges Vielfaches davon, wobei J die skalare Kopplungskonstante ist. Ein solcher Doppelquantenübergang ruft an sich kein meßbares Kernresonanzsignal hervor, jedoch wird dieser Doppelquantenübergang durch den dritten Hochfrequenzimpuls in einen Zustand überführt, in dem er ein meßbares Signal liefert. Wenn nun der zweite Hochfrequenzimpuls in der Weise frequenzselektiv gemacht wird, daß die mit der Lipidkomponente gekoppelten Elemente diesen Impuls nicht "sieht", jedoch die mit der Laktatkomponente gekoppelte Komponente, werden Doppelquantenzustände der störenden Lipidkomponente gar nicht erst angeregt. Infolgedessen wird im Doppelquantenspektrum die Lipidkomponente, die sich praktisch mit der niedrigeren Frequenzkomponente von Milchsäure deckt, weitgehend unterdrückt und die Milchsäurekonzentration kann praktisch unbeeinflußt vom Fettgehalt bestimmt werden.

Dadurch, daß zwischen den drei Hochfrequenzimpulsen wenigstens ein magnetisches Gradientenfeld wirksam ist, dessen zeitliches Integral bei der Wiederholung der Sequenz variiert wird, ergibt sich eine Phasenkodierung, die es (nach einer Fouriertransformation hinsichtlich des zeitlichen Integrals dieses Gradienten) gestattet, die Kernmagnetisierungsverteilung räumlich in mindestens einer Dimension zu bestimmen.

Wäre der zweite Hochfrequenzimpuls ein "harter" Impuls, also nicht frequenzselektiv, dann käme es wesentlich auf die relative Phasenlage der beiden ersten Hochfrequenzimpulse bezüglich des Spinvektors der angeregten Kernspins an. Die Sequenz wäre sehr empfindlich gegenüber ortsabhängigen Phasenverschiebungen, die durch als Folge des Ein- und Ausschaltens der Gradientenfelder auftretende Wirbelströme verursacht werden. Wenn beispielsweise der erste Hochfrequenzimpuls schichtselektiv wäre, wäre eine solche Sequenz kaum für in-vivo-Untersuchungen zu gebrauchen.

Dadurch, daß der zweite Hochfrequenzimpuls frequenzselektiv ist, ist die Phasenbeziehung zwischen den beiden ersten Hochfrequenzimpulsen und den Spinvektoren der angeregten Kernmagnetisierung unwichtig. Daher kann beispielsweise während des ersten Hochfrequenzimpulses oder zwischen dem ersten und dem zweiten Hochfrequenzimpuls ein magnetisches Gradientenfeld wirksam sein, ohne daß sich dadurch Artefakte ergeben. Die Sequenz ist daher sehr robust und eignet sich auch für in-vivo-Untersuchungen.

Es sei an dieser Stelle erwähnt, daß aus der EP-A 370 333 bereits ein Verfahren der eingangs genannten Art bekannt ist, bei dem der dritte Hochfrequenzimpuls frequenzselektiv und bei dem nach dem dritten Hochfrequenzimpuls ein magnetisches Gradientenfeld wirksam ist, dessen zeitliches Integral bei der Wiederholung der Sequenz variiert wird. Bei dieser Sequenz ist der zweite Hochfrequenzimpuls ein "harter" Impuls, so daß diese Sequenz - wie oben erwähnt - empfindlich gegenüber ortsabhängigen Phasenverschiebungen ist.

Weiterhin ist aus der EP-A 404 248 ein Verfahren bekannt, bei dem Sequenzen einer ersten und einer zweiten Art erzeugt werden und die dabei entstehenden Kernresonanzsignale voneinander subtrahiert werden. Die Sequenz der ersten Art umfaßt drei 90°-Hochfrequenzimpulse, von denen der zweite und der dritte vorzugsweise frequenzselektiv sind, und zwar derart, daß - im Gegensatz zur Erfindung - die Kernmagnetisierung der Lipidkomponenten angeregt wird, nicht aber die Kernmagnetisierung der Laktatkomponente. Bei der Sequenz der zweiten Art ist zwischen dem ersten und dem zweiten Hochfrequenzimpuls sowie nach dem dritten Hochfrequenzimpuls zusätzlich je ein 180°-Hochfrequenzimpuls vorgesehen. Zwischen dem ersten und dem zweiten Hochfrequenzimpuls ist ein magnetisches Gradientenfeld wirksam, dessen zeitliches Integral bei der Wiederholung der Sequenzen variiert wird.

In weiterer Ausgestaltung der Erfindung ist vorgesehen, daß die der Phasenkodierung dienenden Gradienten zwischen dem ersten und dem zweiten Hochfrequenzimpuls wirksam sind. Je nach dem, ob ein, zwei der drei Wiederholungen der Sequenz in ihrer Amplitude oder Dauer variierte magnetische Gradientenfelder eingeschaltet sind, ergibt sich damit eine ein-, zwei- oder dreidimensionale Abbildung der räumlichen Verteilung der Kernmagnetisierung. Dazu müssen die bei den Sequenzen empfangenen Kernresonanzsignale außer einer Fouriertransformation nach der Zeit einer ein-, zwei- bzw. dreidimensionalen Fouriertransformation hinsichtlich des zeitlichen Integrals des magnetischen Gradientenfeldes unterzogen werden.

Der erste Hochfrequenzimpuls kann schichtselektiv sein. Dadurch wird die Abbildung der Kernmagnetisierungsverteilung auf eine Schicht beschränkt. Durch die mit diesem magnetischen Gradientenfeld einhergehenden Wirbelströme werden, wie bereits erwähnt, keine Artefakte hervorgerufen, weil der zweite Hochfrequenzimpuls frequenzselektiv ist.

Die Erfindung wird nachstehend anhand der Zeichnung näher erläutert. Es zeigen:

Fig. 1 ein Kernspintomographiegerät, bei dem die Erfindung anwendbar ist,

Fig. 2 das Blockschaltbild eines derartigen Gerätes,

Fig. 3 ein Frequenzdiagramm mit den relevanten Spektralkomponenten von Fett, Wasser und Milchsäure,

Fig. 4 den zeitlichen Verlauf der Signale bei einer erfindungsgemäßen Sequenz,

Fig. 5 den zeitlichen Verlauf des zweiten Hochfrequenzimpulses und

Fig. 6 den zeitlichen Verlauf des dritten Hochfrequenzimpulses.

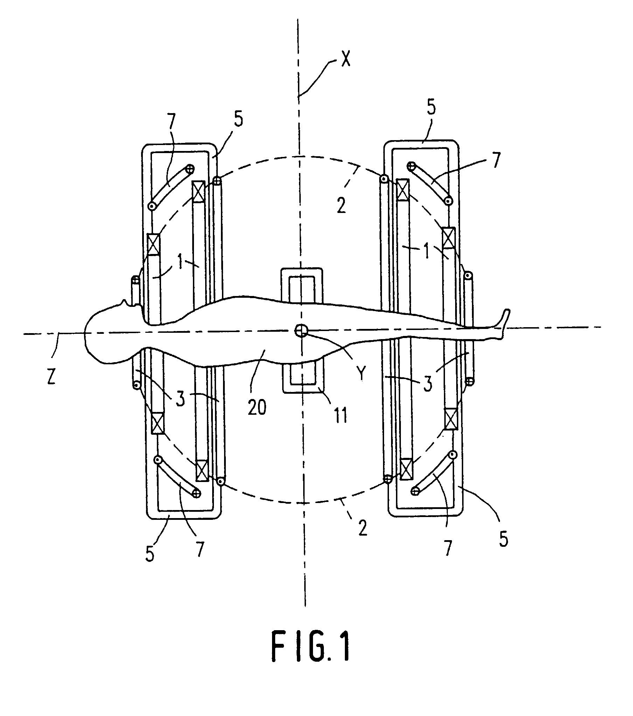

Das in Fig. 1 schematisch dargestellte Kernspinuntersuchungsgerät enthält eine aus vier Spulen 1 bestehende Anordnung zur Erzeugung eines homogenen stationären Magnetfeldes, das in der Größenordnung von einigen zehntel Tesla bis einigen Tesla liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy, Gx symmetrisch zur Kugeloberfläche 2 angeordnet ist, ist die Feldstärke im Kugelzentrum, das gleichzeitig den Koordinatenursprung des erwähnten kartesischen x-y-z-Koordinatensystems bildet, nur durch das stationäre homogene Magnetfeld der Spulenanordnung 1 bestimmt.

Weiterhin ist eine Hochfrequenzspule 11 symmetrisch zur Ebene z=0 des Koordinatensystems angeordnet, die so ausgebildet ist, daß damit ein im wesentlichen homogenes und in x-Richtung, d.h. senkrecht zur Richtung des stationären homogenen Magnetfeldes, verlaufendes hochfrequentes Magnetfeld erzeugt wird. Der Hochfrequenzspule wird während jedes Hochfrequenzimpulses ein hochfrequenter, im allgemeinen amplitudenmodulierter Strom von einem Hochfrequenzgenerator zugeführt. Im Anschluß an die drei Hochfrequenzimpulse jeder Teilsequenz dient die Hochfrequenzspule 11 zum Empfangen des im Untersuchungsbereich erzeugten Kernresonanzsignals. Stattdessen kann aber auch eine gesonderte Hochfrequenzempfangsspule verwendet werden.

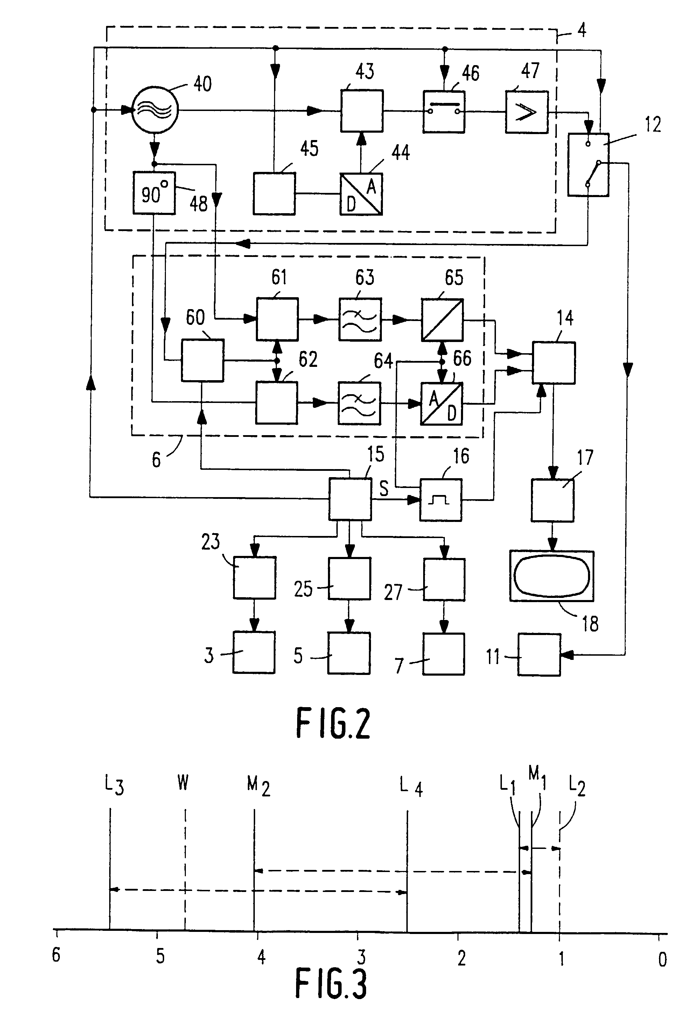

Fig. 2 zeigt ein vereinfachtes Blockschaltbild dieses Kernspinuntersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz von einer Steuereinheit 15 digital steuerbaren Hochfrequenzoszillator 40, der Schwingungen mit einer Frequenz im Bereich der Larmorfrequenz der anzuregenden Atomkerne bei der von den Spulen 1 erzeugten Feldstärke aufweist. Die Larmorfrequenz f berechnet sich bekanntlich nach der Beziehung f=cB, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird - gesteuert durch die Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenzleistungsverstärker 47 zugeführt, dessen Ausgang mit der Umschalteinrichtung 12 verbunden ist. Diese wird ebenfalls durch die Steuereinrichtung 15 gesteuert.

Die Gradientenspulenanordnungen 3, 5 und 7 werden von Stromgeneratoren 23, 25 und 27 jeweils mit einem Strom versorgt, dessen zeitlicher Verlauf durch die Steuereinheit 15 steuerbar ist.

Der Empfänger 6 enthält einen Hochfrequenzverstärker 60, der mit der Umschalteinrichtung verbunden ist und dem das jeweils in der Hochfrequenzspule 11 induzierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils einen dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadraturdemodulator bildenden Schaltung 61..64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die im Speicher 14 gespeicherten Datenworte bzw. Abtastwerte werden einem Rechner 17 zugeführt. Die Abtastwerte lassen sich durch drei Parameter definieren: Ihre zeitliche Lage innerhalb des Kernresonanzsignals, die Größe eines ersten magnetischen Gradientenfeldes, das bei der Sequenz, bei der das Kernresonanzsignal empfangen wurde, zwischen dem ersten und dem zweiten Hochfrequenzimpuls wirksam war, und die Größe eines zweiten magnetischen Gradientenfeldes, das im gleichen Zeitraum wirksam war. Durch eine dreidimensionale Fouriertransformation hinsichtlich dieser drei Parameter, die in dem Rechner 17 durchgeführt wird, ergibt sich daraus für eine Schicht innerhalb des Untersuchungsobjektes die zweidimensiomale räumliche Verteilung der Kernmagnetisierung und für jeden Bereich innerhalb dieser Schicht die spektrale Verteilung der Kernmagnetisierung. Die auf diese Weise gewonnene Verteilung kann an einer geeigneten Wiedergabeeinheit, z.B. einem Monitor 18, ausgegeben werden.

Fig. 3 zeigt die Lage der für den klinischen Nachweis von Milchsäure wesentlichen Komponenten auf einer Frequenzskala, die die Abweichung von der Larmorfrequenz von TMS (Tetramethylsilan) angibt (in ppm). Die Larmorfrequenz von TMS liegt somit definitionsgemäß bei Null. Fig. 3 zeigt oberhalb des Nullpunkts

zunächst eine Linie $L_2$, die von einer $CH_3$-Gruppe des Fettmoleküls herrührt. Diese Gruppe ist mit einer $CH_2$-Gruppe gekoppelt, die eine Frequenzlinie $L_1$ bei ca. 1,4 ppm aufweist. Diese skalare Kopplung ist durch die gestrichelten Linie zwischen $L_1$ und $L_2$ symbolisiert. Bei geeigneter Anregung weist die der Linie $L_1$ zugeordnete Molekülgruppe einen Doppelquantenübergang auf, während bei der Linie $L_2$ kein solcher Übergang erzeugt werden kann. Die Linie $L_2$ verschwindet also im Doppelquantenspektrum und ist daher in Fig. 3 nur gestrichelt angedeutet.

In unmittelbarer Nähe der Linie $L_1$ befindet sich eine Linie $M_1$ (bei ca. 1,33 ppm), die von der $CH_3$-Gruppe von Laktat herrührt. Diese $CH_3$-Gruppe ist skalar mit einer CH-Gruppe des Milchsäuremoleküls gekoppelt, deren Lamorfrequenz bei 4,1 ppm liegt. Beide Frequenzlinien erscheinen im Doppelquantenspektrum. Die Frequenzlinie W von an Wasser gebundenen Protonen liegt bei ca. 4,7 ppm. Diese Protonen können zwar an sich nicht in einen Doppelquantenzustand übergehen - weshalb die Frequenzlinie W ebenfalls gestrichelt dargestellt ist - doch läßt sich die Wasserkomponente, deren Intensität im biologischen Gewebe mehrere Zehnerpotenzen größer ist als die aller anderen Komponenten, nicht vollständig unterdrücken, und daher scheint diese Linie auch im Doppelquantenspektrum. Außerdem sind noch weitere Linien $L_3$ und $L_4$ dargestellt, die von Molekülgruppen des Fettmoleküls herrühren.

In biologischem Gewebe ist die Wasserkomponente W, auch wenn sie durch ein Verfahren der eingangs genannten Art um einen Faktor von z.B. 1000 unterdrückt worden ist, noch immer so intensiv, daß die in ihrer Nähe befindliche Milchsäurekomponente $M_2$ im Doppelquantenspektrum davon nicht getrennt werden kann. Die Milchsäurekomponente $M_1$ befindet sich so dicht bei der Fettkomponente $L_1$, daß auch hier eine getrennte Messung nicht möglich ist, wenn im Untersuchungsbereich ein erheblicher Fettanteil enthalten ist, wie beispielsweise im Muskelgewebe. Eine unzweideutige Bestimmung des Milchsäuregehaltes aus einer Messung der Komponente $M_1$ ist daher nur möglich, wenn die ihr frequenzmäßig unmittelbar benachbarte Fettkomponente $L_1$ stark unterdrückt wird.

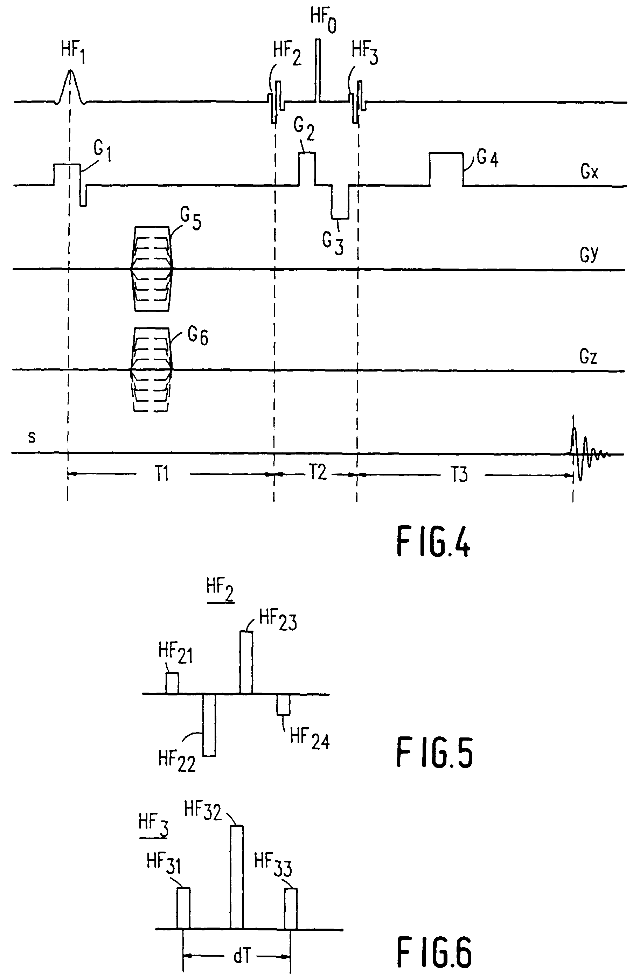

Diese Unterdrückung wird durch eine Sequenz erreicht, deren zeitlicher Verlauf in Fig. 4 dargestellt ist. Die erste Zeile von Fig. 4 zeigt die zeitliche Lage der von der Hochfrequenzspule 11 erzeugten magnetischen Hochfrequenzimpulse. Die zweite, dritte und vierte Zeile zeigt die zeitliche Lage der mittels der Gradientenspulen 7, 5 und 3 erzeugten magnetischen Gradientenfelder, deren Gradienten $G_x$, $G_y$ bzw. $G_z$ in x-, y- bzw. z-Richtung verlaufen. In der fünften Zeile ist das auftretende Kernresonanzsignal gezeichnet. Bei der Erfassung dieses Signales gibt die Steuereinheit 15 den Taktimpulsgenerator 16 frei, so daß die von der Hochfrequenzspule 11 gelieferten, in den Niederfrequenzbereich transponierten Kernresonanzsignale in eine Folge digitaler Datenworte umgesetzt und im Speicher 14 gespeichert werden können, wonach sie einer Fouriertransformation unterzogen werden.

Der erste Hochfrequenzimpuls $HF_1$ ist ein schichtselektiver 90°-Hochfrequenzimpuls, weil während dieses Impulses ein magnetisches Gradientenfeld $G_1$ mit einem in x-Richtung verlaufenden Gradienten wirksam ist. Dadurch wird die Kernmagnetisierung der in Fig. 3 dargestellten Frequenzkomponenten in einer Schicht angeregt, die senkrecht zur x-Achse verläuft und deren Dicke von der Bandbreite des Hochfrequenzimpulses $HF_1$ und von der Größe des Gradienten $G_1$ abhängt. Der Gradient $G_1$ könnte statt in x-Richtung auch in y- oder in z-Richtung verlaufen. Dann würde die Kernmagnetisierung in einer zur y- bzw. z-Achse senkrechten Schicht angeregt werden.

Im zeitlichen Abstand T1 vom ersten Hochfrequenzimpuls $HF_1$ wird ein zweiter Hochfrequenzimpuls $HF_2$ erzeugt. Dabei entspricht T1 dem Wert 1/2J, wobei J die skalare Kopplungskonstante von Milchsäure bzw. Fett ist - oder einem n-fachen davon, wobei n eine ungerade Zahl ist. Mit n = 1 beträgt T1 etwa 68 ms.

Der zweite Hochfrequenzimpuls $HF_2$ ist ein frequenzselektiver Hochfrequenzimpuls, der für die mit der nachzuweisenden Laktatkomponente $M_1$ gekoppelte Komponente $M_2$ als 90°-Impuls wirksam ist und für die Lipidkomponente $L_2$ (und damit auch für $L_1$ und $M_1$ als 0°-Impuls, d.h., diese Komponenten werden nicht beeinflußt. Deshalb werden durch diesen Impuls nur die Milchsäurekomponenten $M_1$ und $M_2$ (wegen der skalaren Kopplung mit $M_1$) in einen Doppelquantenzustand überführt, aber nicht die Lipidkomponente $L_1$.

In Fig. 5 ist der frequenzselektive zweite Hochfrequenzimpuls $HF_2$ dargestellt. Dabei handelt es sich um einen sogenannten binomialen Hochfrequenzimpuls. Ein binomialer Hochfrequenzimpuls besteht bekanntlich aus einer Folge von Teilpulsen, deren zugeordnete Flipwinkel (das ist der Winkel, in dem die Kernmagnetisierung durch einen solchen Teilpuls aus der Ruhelage gekippt wird) im gleichen Verhältnis zueinander stehen wie die Binomialkoeffizienten.

Der zeitliche Abstand zwischen zwei aufeinanderfolgenden Teilpulsen ist so gewählt, daß eine Schwingung, deren Frequenz die Differenz der anzuregenden und der zu unterdrückenden Frequenz entspricht, innerhalb dieses Zeitraums ihre Phase gerade um Null oder ein ungeradzahliges Vielfaches davon geändert hat. Die Mittenfrequenz dieser Teilpulse fällt mit einer der beiden zuvorgenannten Frequenzen zusammen.

In Fig. 5 ist der frequenzselektive Hochfrequenzimpuls $HF_2$ als $1,\bar{3},3,\bar{1}$ Hochfrequenzimpuls dargestellt, der aus den vier Teilpulsen $HF_{21}..HF_{24}$ besteht. Die Mittenfrequenz jedes dieser Hochfrequenzimpulse entspricht der Larmorfrequenz der Fettkomponente $L_2$. Der zweite und der vierte Teilpuls $HF_{22}$ bzw. $HF_{24}$ haben die entgegengesetzten Phasenlage wie die Teilpulse $HF_{21}$ und $HF_{23}$. Der zeitliche Abstand zwischen jeweils zwei aufeinanderfolgenden Teilpulsen beträgt 1/2df, wobei df die Differenzfrequenz zwischen $M_2$ und $L_2$ ist. Bei einer

magnetischen Flußdichte des homogenen stationären Magnetfeldes von 2T ergibt sich somit ein Abstand zwischen den Teilpulsen von rund 1,9 ms. Der erste und der letzte Teilpuls $HF_{21}$ bzw. $HF_{22}$ haben einen Flipwinkel von jeweils 11,25°, während der Flipwinkel der Hochfrequenzimpulse $HF_{22}$ und $HF_{23}$ dreimal so groß ist. Für Kernspins, deren Larmorfrequenz der Mittenfrequenz der Teilpulse entspricht (wie z.B. für $L_2$), kompensieren sich die Wirkungen der Hochfrequenzimpulse $HF_{21}$ und $HF_{24}$ bzw. $HF_{22}$ und $HF_{23}$. Für die Komponente $M_2$ hingegen addiert sich die Wirkung der Impulse $HF_{21}..HF_{24}$, so daß die mit den einzelnen Teilpulsen verknüpften Flipwinkel sich für diese Komponente addieren und sich dafür die Wirkung eines 90°-Hochfrequenzimpulses ergibt.

Die Teilpulse $HF_{22}$ und $HF_{24}$ können auch die gleiche Phasenlage haben wie die Teilpulse $HF_{21}$ und $HF_{23}$. In diesem Fall muß die Mittenfrequenz dieser Teilpulse mit der Frequenz der Komponente $M_2$ zusammenfallen.

Im zeitlichen Abstand T2 vom zweiten Hochfrequenzimpuls $HF_2$ folgt ein dritter Hochfrequenzimpuls $HF_3$. Dieser Impuls dient dazu, die durch $HF_2$ hervorgerufenen Doppelquantenübergänge in einen Zustand zu überführen, in dem sie ein Kernresonanzsignal erzeugen bzw. einen Beitrag dazu liefern. Der Hochfrequenzimpuls $HF_3$ kann ein harter (breitbandiger) Impuls sein, ist aber vorzugsweise ebenfalls ein frequenzselektiver Impuls, und zwar in der Weise, daß er bei der Frequenzkomponente $M_2$ als 90°-Impuls wirksam ist. Dadurch wird die Amplitude des Laktat-Signals verdoppelt.

Der Impuls $HF_3$ kann dabei denselben zeitlichen Verlauf haben wie $HF_2$, der für $M_2$ als 90°-Impuls und für $L_2$ als 0°-Impuls wirkt, wie in Fig. 4 dargestellt. In der Mitte zwischen dem zweiten und dem dritten Hochfrequenzimpuls $HF_2$ und $HF_3$ kann noch ein 180°-Hochfrequenzimpuls $HF_0$ vorgesehen sein. Dieser wirkt refokussierend, so daß die Amplitude des Kernresonanzsignales vergrößert wird.

Ohne zusätzliche Maßnahmen würden nach dem dritten Hochfrequenzimpuls $HF_3$ neben den in einen beobachtbaren Zustand überführten Doppelquantkohärenzen Einfachquantkohärenzen sichtbar werden. Die letzteren werden dadurch unterdrückt, daß zwischen den Hochfrequenzimpulsen $HF_2$ und $HF_3$ sowie nach dem Hochfrequenzimpuls $HF_3$ magnetische Gradientenfelder $G_2$, $G_3$ und $G_4$ eingeschaltet werden, deren Gradienten in derselben Richtung bzw. entgegengesetzten Richtungen verlaufen. Zwischen den Hochfrequenzimpulsen $HF_2$ und $HF_3$ ist das magnetische Gradientenfeld in zwei Teile $G_2$ und $G_3$ aufgeteilt, die vor bzw. nach dem 180°-Hochfrequenzimpuls $HF_0$ wirksam sind und entgegengesetztes Vorzeichen haben. Die zeitlichen Integrale über $G_2$ und $G_3$ können den gleichen Betrag haben, doch sind auch andere Aufteilungen möglich. Das magnetische Gradientenfeld $G_4$ muß bei der in Fig. 4 dargestellten Sequenz dasselbe Vorzeichen haben wie $G_2$, und das zeitliche Integral über $G_4$ muß doppelt so groß sein wie das zeitliche Integral über die Summe der Beträge von $G_2$ und $G_3$.

Wenn $HF_0$ weggelassen wird und $HF_3$ denselben zeitlichen Verlauf hat wie $HF_2$, dann haben diese Gradienten das entgegengesetzte Vorzeichen. Auch dann muß das zeitliche Integral über das betreffende Gradientenfeld im Intervall zwischen $HF_2$ und $HF_3$ dem Betrage nach halb so groß sein wie das zeitliche Integral über das Gradientenfeld nach $HF_3$.

Der Impuls $HF_3$ kann auch in der Weise frequenzselektiv sein, daß er bei $M_2$ als 90°-Impuls und bei $M_1$ als 180°-Impuls wirksam ist. Da sich der Flipwinkel des dritten Hochfrequenzimpulses $HF_3$ um die Frequenz der Komponente $M_1$ herum nicht abrupt ändern kann, wirkt der dritte Hochfrequenzimpuls auch für die zu $M_1$ frequenzmäßig benachbarten Fettkomponenten $L_1$ und $L_2$ als 180°-Impuls. Somit "sieht" auch die Fettkomponente $L_2$ keinen 90°-Impuls sondern einen 180°-Impuls, so daß etwaige Doppelquantenkohärenzzustände der Fettkomponenten nicht in einem beobachtbaren Quantenkohärenzzustand überführt werden.

Der die Refokussierung bewirkende 180°-Hochfrequenzimpuls $HF_0$ darf in diesem Fall nicht in der Mitte zwischen $HF_2$ und $HF_3$ liegen sondern muß dem ersten Hochfrequenzimpuls im gleichen zeitlichen Abstand folgen, in dem der dritte Impuls $HF_3$ dem zweiten Impuls folgt. Das zeitliche Integral über das zwischen $HF_2$ und $HF_3$ wirksame Gradientenfeld muß dann das gleiche Vorzeichen haben und halb so groß sein wie das zeitliche Integral nach dem dritten Hochfrequenzimpuls $HF_3$.

In Fig. 6 ist ein Hochfrequenzimpuls $HF_3$ dargestellt, der bei $M_2$ als 90°-Impuls und bei $M_1$ als 180°-Impuls wirkt. Der Hochfrequenzimpuls $HF_3$ umfaßt danach zwei identische 45°-Teilpulse $HF_{31}$ und $HF_{33}$, zwischen denen sich - in der Mitte - ein "harter" und somit breitbandiger 90°-Teilpuls $HF_{32}$ befindet. Für den zeitlichen Abstand dT zwischen den beiden Teilpulsen $HF_{31}$ und $HF_{33}$ gilt die Beziehung $dT = n/2df$, wobei n eine ungerade Zahl und df die Frequenzdifferenz zwischen den Larmorfrequenzen der Komponenten $M_1$ und $M_2$ (bei einem stationären Feld von 2T ca. 235 Hz) ist. Wenn die Mittenfrequenz der Teilpulse $HF_{31}$ und $HF_{33}$ mit der Larmorfrequenz der Milchsäurekomponente $M_1$ zusammenfällt, müssen alle Teilpulse die gleiche Phasenlage haben. Die Wirkungen der Teilpulse $HF_{31}$ und $HF_{33}$ kompensieren sich dann für die Milchsäurekomponente $M_2$, und sie addieren sich für die Milchsäurekomponente $M_1$, so daß letztere diese beiden Teilpulse als 90°-Impuls erfährt. Zusätzlich wirkt auf die genannten Komponenten - und alle übrigen Komponenten der Fig. 3 - der Teilpuls $HF_{32}$ ein. Somit wirkt der Hochfrequenzimpuls $HF_3$ für die Komponente $M_2$ als 90°-Impuls und für die Komponente $M_2$ als 180°-Impuls, was zur Folge hat, daß die Amplitude des Doppelquantenüberganges $M_1$ im Kernresonanzsignal verdoppelt wird.

Es ist auch möglich, die Mittenfrequenz der Teilpulse $HF_{31}$ und $HF_{33}$ entsprechend der Frequenzkomponente $M_2$ zu wählen (ca. 4,1 ppm). In diesem Fall muß die Phase des Teilpulses $HF_{33}$ der Phase des Teilpulses

HF$_{32}$ um 90° vorauseilen, während die Phase von HF$_{31}$ der Phase von HF$_{32}$ nacheilen muß.

Die Frequenzabhängigkeit des Flipwinkels von HF$_3$ zwischen M$_2$ und M$_1$ ändert sich cosinusförmig von 90° auf 180°. Infolgedessen ist der Flipwinkel für die Fettkomponenten L$_1$ und L$_2$, die frequenzmäßig relativ dicht bei M$_1$ liegen, nahezu 180°. Da somit die Komponente L$_2$ keinen 90°-Impuls sieht, werden etwaige Doppelquantenübergänge bei der Fettkomponente L$_1$ allenfalls in vernachlässigbar kleinem Maße in einen Einfachquantenzustand überführt, in dem sie beobachtbar werden.

Die durch den dritten Hochfrequenzimpuls HF$_3$ von einem Doppelquantenzustand in einen Einfachquantenzustand überführten Kernspinsysteme liefern ein Kernresonanzsignal, das seinen maximalen Wert zu einer Zeit T3=(2m+1)/2J nach dem dritten Hochfrequenzimpuls erreicht, wobei m eine ganze Zahl ist, die nicht kleiner ist als Null. In diesem Zeitpunkt beginnt die Abtastung des in der fünften Zeile von Fig. 4 dargestellten Kernresonanzsignals, d.h. die Steuereinheit 15 (Fig. 2) gibt dann den Impulsgenerator 16 frei, so daß das Kernresonanzsignal digitalisiert und gespeichert werden.

Zur Erzielung einer räumlichen Darstellung werden zwischen dem ersten Hochfrequenzimpuls HF$_1$ und dem zweiten Hochfrequenzimpuls HF$_2$ magnetische Gradientenfelder G$_5$ und G$_6$ mit in y- bzw. z-Richtung - d.h. senkrecht zu der durch HF$_1$ und G$_1$ angeregten Schicht - verlaufendem Gradienten erzeugt, wobei von Sequenz zu Sequenz entweder der Gradient G$_5$ oder der Gradient G$_6$ geändert wird, so daß das Kernresonanzsignal s(t,G$_5$,G$_6$) von den Parametern G$_5$ und G$_6$ sowie von der zeitlichen Lage t des jeweiligen Abtastwertes innerhalb eines Kernresonanzsignals abhängt. Unterzieht man diese Werte einer dreifachen Fouriertransformation hinsichtlich der genannten drei Parameter, dann erhält man einen Datensatz, der die Kernmagnetisierung in der angeregten Schicht als Funktion des Ortes darstellt, wobei sich für jeden Punkt y, z zugleich auch noch die spektrale Verteilung der Kernmagnetisierung ergibt.

Wenn - wie im Ausführungsbeispiel - die Gradientenfelder G$_5$, G$_6$ vor den Hochfrequenzimpulsen HF$_0$, HF$_2$ und HF$_3$ erzeugt werden, werden die von HF$_2$, HF$_3$ und HF$_0$ erzeugten unerwünschten FID-Signale nicht von den Gradienten G$_5$ bzw. G$_6$ beeinflußt. Die dadurch hervorgerufene Störung erscheint daher nach der Fouriertransformation in der Bildmitte. Durch ein geeignetes Phasencycling, bei dem z.B. bei jeder zweiten Sequenz die Phase des ersten Hochfrequenzimpulses bzw. die Empfängerphase invertiert wird, läßt sich diese Störung zu den Bildecken verschieben.

In Fig. 4 ist eine Sequenz für die zweidimensionale spektroskopische Abbildung dargestellt. Stattdessen ist aber auch eine eindimensionale Abbildung möglich, wobei einer der Gradienten G$_5$ oder G$_6$ (und dessen Variationen bei den aufeinanderfolgenden Sequenzen) entfallen können. Dann muß auch HF$_0$ schichtselektiv sein, damit die spektrale Verteilung längs eines in y- oder z-Richtung verlaufenden Streifens wiedergegeben werden kann.

Ebenso ist es auch möglich, zusätzlich zur spektralen Verteilung die räumliche Verteilung der Kernmagnetisierung dreidimensional zu ermitteln. In diesem Fall kann HF$_1$ ein harter (nicht schichtselektiver) Hochfrequenzimpuls sein und zwischen HF$_1$ und HF$_2$ muß zusätzlich ein magnetisches Gradientenfeld mit in -Richtung verlaufendem Gradienten Gx eingeschaltet werden, der von Sequenz zu Sequenz variiert wird. Die gesuchte Verteilung ergibt sich dann aus einer vierfachen Fouriertransformation.

## Patentansprüche

1. Kernresonanzspektroskopieverfahren, bei dem in Anwesenheit eines homogenen stationären Magnetfeldes auf einen Untersuchungsbereich eine Vielzahl von Sequenzen einwirkt, von denen jede wenigstens drei vorzugsweise als 90°-Impulse ausgebildete Hochfrequenzimpulse umfaßt, wobei zwischen dem zweiten und dem dritten Hochfrequenzimpuls sowie nach dem dritten Hochfrequenzimpuls magnetische Gradientenfelder (Gx) mit solcher Amplitude und Dauer wirksam werden, daß nach dem dritten Hochfrequenzimpuls auftretende Kernresonanzsignale nur durch Doppelquantenkohärenz bestimmt sind,
dadurch gekennzeichnet, daß zwischen den drei Hochfrequenzimpulsen wenigstens ein magnetisches Gradientenfeld (G$_5$,G$_6$) wirksam ist und das zeitliche Integral über wenigstens eines dieser Gradientenfelder bei der Wiederholung der Sequenzen variiert wird und daß zur Reduzierung der Lipidkomponente (L$_1$) im Bereich der Laktatkomponente (M$_1$) der zweite Hochfrequenzimpuls (HF$_2$) derart frequenzselektiv ist, daß er die Kernmagnetisierung der mit der Laktatkomponente (M$_1$) gekoppelten Komponente (M$_2$) anregt, aber nicht die Kernmagnetisierung der mit der Lipidkomponente (L$_1$) gekoppelten Komponente (L$_2$).

2. Kernresonanzspektroskopieverfahren nach Anspruch 1,
dadurch gekennzeichnet, daß die der Phasenkodierung dienenden Gradienten (G$_5$,G$_6$) zwischen dem ersten und dem zweiten Hochfrequenzimpuls wirksam sind.

3. Kernresonanzspektroskopieverfahren nach einem der vorhergehenden Ansprüche,
dadurch gekennzeichnet, daß zwischen dem zweiten (HF$_2$) und dem dritten Hochfrequenzimpuls (HF$_3$) ein 180°-Impuls (HF$_0$) vorgesehen ist.

4. Kernresonanzspektroskopieverfahren nach Anpruch 3,

dadurch gekennzeichnet, daß im Intervall (T2) zwischen dem zweiten und dem dritten Hochfrequenzimpuls vor und nach dem 180°-Impuls (HF$_0$) ein magnetisches Gradientenfeld mit einander entgegengerichteten Gradienten erzeugt wird und daß die Summe der Beträge der zeitlichen Integrale über diese Gradientenfelder halb so groß ist wie das zeitliche Integral über das magnetische Gradientenfeld, das nach dem dritten Hochfrequenzimpuls erzeugt wird und dessen Gradient in der gleichen Richtung bzw. entgegengesetzt dazu verläuft.

5. Kernresonanzspektroskopieverfahrne nach einem der Ansprüche 1 bis 4,
dadurch gekennzeichnet, daß der dritte Hochfrequenzimpuls (HF$_3$) derart frequenzselektiv ist, daß er für die mit der Laktatkomponente (M$_1$) gekoppelte Komponente (M$_2$) als 90°-Impuls wirksam ist und für die mit der Lipidkomponente (L$_1$) gekoppelte Komponente (L$_2$) als 0°-Impuls, und daß der Gradient des nach dem zweiten Hochfrequenzimpuls (HF$_2$) zunächst wirksamen magnetischen Gradientenfeldes (G$_2$) die gleiche Polarität hat wie der Gradient (G$_4$) des nach dem dritten Hochfrequenzimpuls wirksamen magnetischen Gradientenfeldes.

6. Kernresonanzspektroskopieverfahren nach einem der Ansprüche 1 oder 2,
dadurch gekennzeichnet, daß nach dem ersten Hochfrequenzimpuls ein 180°-Impuls (HF$_0$) erzeugt wird, der von dem ersten Hochfrequenzimpuls (HF$_1$) den gleichen zeitlichen Abstand (T2) hat wie der dritte Hochfrequenzimpuls (HF$_3$) vom zweiten Hochfrequenzimpuls (HF$_2$), daß der Gradient (G$_2$) des nach dem zweiten Hochfrequenzimpuls (HF$_2$) zunächst wirksamen magnetischen Gradientenfeldes in der entgegengesetzten Richtung verläuft wie der Gradient (G$_4$) des nach dem dritten Hochfrequenzimpuls (HF$_3$) wirksamen magnetischen Gradientenfeldes, und daß der dritte Hochfrequenzimpuls (HF$_3$) derart frequenzselektiv ist, daß er für die mit der Laktatkomponente (M$_1$) gekoppelte Komponente (M$_2$) als 90°-Impuls wirksam ist und für die Laktatkomponente (M$_1$) als 180°-Impuls.

7. Kernresonanzspektroskopieverfahren nach einem der Ansprüche 1 bis 6,
dadurch gekennzeichnet, daß der erste Hochfrequenzimpuls (HF$_1$) und/oder der 180°-Impuls schichtselektiv ist.

8. Anordnung zur Durchführung des Verfahrens nach einem der vorhergehenden Ansprüche,
gekennzeichnet durch einen Magneten (1) zur Erzeugung eines homogenen stationären Magnetfeldes, eine Hochfrequenzspulenanordnung (11) zur Erzeugung von Hochfrequenzsignalen und zum Empfangen von Kernresonanzsignalen, einem Hochfrequenzsender (4) zum Erzeugen von Sequenzen mit wenigstens drei Hochfrequenzimpulsen (HF$_1$...HF$_3$), von denen der zweite (HF$_2$) derart frequenzselektiv ist, daß er für die Laktatkomponente (M$_2$) als 90°- und für die Lipidkomponente (L$_2$) als 0°-Impuls wirksam ist, einen Hochfrequenzempfänger (6) zum Empfangen der jeweils nach dem dritten Hochfrequenzimpuls (HF$_3$) auftretenden Kernresonanzsignale, Mittel (17) zum Bestimmen des Spektrums und der Kernmagnetisierungsverteilung aus den Kernresonanzsignalen, Gradientenspulenanordnungen (3, 5, 7) zum Erzeugen magnetischer Gradientenfelder und einer Steuereinheit 15, die derart programmiert ist, daß zwischen den drei Hochfrequenzimpulsen wenigstens ein magnetisches Gradientenfeld (G$_5$, G$_6$) wirksam ist und das zeitliche Integral über wenigstens eines dieser Gradientenfelder bei der Wiederholung der Sequenzen variiert wird.

## Claims

1. A magnetic resonance spectroscopy method in which a plurality of sequences acts on an examination zone in the presence of a uniform, steady magnetic field, each sequence comprising at least three, preferably 90° RF pulses, between the second and the third RF pulse as well as after the third RF pulse there being activated magnetic gradient fields (G$_x$) having an amplitude and duration such that spin resonance signals occurring subsequent to the third RF pulse are determined exclusively by double quantum coherence,
characterized in that between the three RF pulses at least one magnetic gradient field (G$_5$, G$_6$) is active, the time integral over at least one of these gradient fields being varied during repetition of the sequences, the second RF pulse (HF$_2$) being frequency-selective in order to reduce the lipid component (L$_1$) in the vicinity of the lactate component (M$_1$) so that it excites the nuclear magnetization of the component (M$_2$) coupled to the lactate component (M$_1$) but not the nuclear magnetization of the component (L$_2$) coupled to the lipid component (L$_1$).

2. A magnetic resonance spectroscopy method as claimed in Claim 1,
characterized in that the gradients (G$_5$, G$_6$) serving for phase encoding are active between the first and the second RF pulse.

3. A magnetic resonance spectroscopy method as claimed in any one of the preceding Claims,
characterized in that a 180° pulse (HF$_0$) is applied between the second RF pulse (HF$_2$) and the third RF pulse (HF$_3$).

4. A magnetic resonance spectroscopy method as claimed in Claim 3,
characterized in that during the interval (T2) between the second and the third RF pulse a magnetic gradient field having opposed gradients is generated before and after the 180° pulse (HF$_0$), the sum of the absolute values of the time integrals over these gradient fields amounting to half the time integral over the magnetic gradient field which is generated after the third RF pulse and whose gradient extends in the same direction and in the opposite direction, respectively.

5. A magnetic resonance spectroscopy method as claimed in any one of the Claims 1 to 4,
characterized in that the third RF pulse (HF$_3$) is frequency-selective so that it acts as a 90° pulse for the component (M$_2$) coupled to the lactate component (M$_1$) and as a 0° pulse for the component (L$_2$) coupled to the lipid component (L$_1$), the gradient of the magnetic gradient field (G$_2$) first active after the second RF pulse (HF$_2$) having the same polarity as the gradient (G$_4$) of the magnetic gradient field active after the third RF pulse.

6. A magnetic resonance spectroscopy method as claimed in any one of the Claims 1 or 2,
characterized in that after the first RF pulse there is generated a 180° pulse (HF$_0$) which is situated at a distance in time (T2) from the first RF pulse (HF$_1$) which is equal to the distance in time between the third RF pulse (HF$_3$) and the second RF pulse (HF$_2$), the gradient (G$_2$) of the magnetic gradient field first active after the second RF pulse (HF$_2$) extending in the opposite direction with respect to the gradient (G$_4$) of the magnetic gradient field active after the third RF pulse (HF$_3$), the third RF pulse (HF$_3$) being frequency-selective so that it acts as a 90° pulse for the component (M$_2$) coupled to the lactate component (M$_1$) and as a 180° pulse for the lactate component (M$_1$).

7. A magnetic resonance spectroscopy method as claimed in any one of the Claims 1 to 6,
characterized in that the first RF pulse (HF$_1$) and/or the 180° pulse is slice-selective.

8. A device for performing the method claimed in any one of the preceding Claims,
characterized in that it comprises a magnet (1) for generating a uniform, steady magnetic field, an RF coil system (11) for generating RF signals and for receiving spin resonance signals, an RF transmitter (4) for generating sequences comprising at least three RF pulses (HF$_1$ ... HF$_3$), the second (HF$_2$) of which is frequency-selective so that it acts as a 90° pulse for the lactate component (M$_2$) and as a 0° pulse for the lipid component (L$_2$), an RF receiver (6) for receiving the spin resonance signals appearing each time after the third RF pulse (HF$_3$), means (17) for determining the spectrum and the nuclear magnetization distribution from the spin resonance signals, gradient coil systems (3,5,7) for generating magnetic gradient fields, and a control unit 15 which is programmed so that at least one magnetic gradient field (G$_5$, G$_6$) is active between the three RF pulses and that the time integral over at least one of these gradient fields is varied during the repetition of the sequences.

**Revendications**

1. Procédé de spectroscopie à résonance magnétique nucléaire, plusieurs séquences dont chacune comprend au moins trois impulsions à haute fréquence formées de préférence comme des impulsions à 90° agissant en présence d'un champ magnétique stationnaire homogène sur une zone d'examen, des champs magnétiques à gradient (G$_x$) agissant entre les deuxième et troisième impulsions à haute fréquence ainsi qu'après la troisième impulsion à haute fréquence avec une amplitude et une durée telles que les signaux de résonance magnétique nucléaire apparaissant après la troisième impulsion à haute fréquence ne sont déterminés que par une cohérence à double quantum,
caractérisé en ce qu'entre les trois impulsions à haute fréquence, au moins un champ à gradient magnétique (G$_5$, G$_6$) est actif et l'intégrale temporelle varie sur au moins un de ces champs à gradient en cas de répétition des séquences et qu'en vue de la réduction de la composante de lipide (L$_1$) dans la région de la composante de lactate (M$_1$) la deuxième impulsion à haute fréquence (HF$_2$) est sélective sur le plan de la fréquence de telle sorte qu'elle excite la magnétisation nucléaire de la composante (M$_2$) couplée à la composante de lactate (M$_1$) mais pas la magnétisation nucléaire de la composante (L$_2$) couplée à la composante de lipide (L$_1$).

2. Procédé de spectroscopie à résonance magnétique nucléaire selon la revendication 1, caractérisé en ce que les gradients (G$_5$, G$_6$) servant au codage de phases sont actifs entre les première et deuxième impulsions à haute fréquence.

3. Procédé de spectroscopie à résonance magnétique nucléaire selon l'une des revendications précédentes, caractérisé en ce qu'une impulsion à 180° (HF$_0$) est prévue entre les deuxième (HF$_2$) et troisième impulsions à haute fréquence (HF$_3$).

4. Procédé de spectroscopie à résonance magnétique nucléaire selon la revendication 3, caractérisé en ce que, dans l'intervalle (T2) entre les deuxième et troisième impulsions à haute fréquence avant et après l'impulsion à 180° ($HF_0$), un champ à gradient magnétique est généré avec des gradients réciproquement opposés et que la somme des valeurs des intégrales temporelles sur ces champs à gradient est égale à la moitié de l'intégrale temporelle sur le champ à gradient magnétique qui est produit après la troisième impulsion à haute fréquence et dont le gradient s'étend dans la même direction ou dans la direction opposée.

5. Procédé de spectroscopie à résonance magnétique nucléaire selon l'une des revendications 1 à 4, caractérisé en ce que la troisième impulsion à haute fréquence ($HF_3$) est sélective sur le plan de la fréquence de telle sorte qu'elle agisse pour la composante ($M_2$) couplée à la composante de lactate ($M_1$) comme une impulsion à 90° et pour la composante ($L_2$) couplée à la composante de lipide ($L_1$) comme une impulsion à 0° et que le gradient du champ à gradient magnétique ($G_2$) agissant d'abord après la deuxième impulsion à haute fréquence ($HF_2$) présente la même polarité que le gradient ($G_4$) du champ à gradient magnétique agissant après la troisième impulsion à haute fréquence.

6. Procédé de spectroscopie à résonance magnétique nucléaire selon l'une des revendications 1 ou 2, caractérisé en ce qu'après la première impulsion à haute fréquence est générée une impulsion à 180° ($HF_0$) qui a le même intervalle temporel (T2) par rapport à la première impulsion à haute fréquence ($HF_1$) que la troisième impulsion à haute fréquence ($HF_3$) de la deuxième impulsion à haute fréquence ($HF_2$), que le gradient ($G_2$) du champ à gradient magnétique agissant d'abord après la deuxième impulsion à haute fréquence ($HF_2$) s'étend en direction opposée au gradient ($G_4$) du champ à gradient magnétique agissant après la troisième impulsion à haute fréquence ($HF_3$) et que la troisième impulsion à haute fréquence ($HF_3$) est sélective sur le plan de la fréquence de telle sorte qu'elle agisse pour la composante ($M_2$) couplée à la composante de lactate ($M_1$) comme une impulsion à 90° et pour la composante de lactate ($M_1$) comme une impulsion à 180°.

7. Procédé de spectroscopie à résonance magnétique nucléaire selon l'une des revendications 1 à 6, caractérisé en ce que la première impulsion à haute fréquence ($HF_1$) et/ou l'impulsion à 180° est sélective sur le plan de la couche.

8. Dispositif de mise en oeuvre de procédé selon l'une des revendications précédentes, caractérisé par un aimant (1) en vue de générer un champ magnétique stationnaire homogène, un agencement de bobines à haute fréquence (11) en vue de générer des signaux de haute fréquence et de recevoir des signaux de résonance magnétique nucléaire, un émetteur de hautes fréquences (4) pour la production de séquences avec au moins trois impulsions à haute fréquence ($HF_1$...$HF_3$) dont la deuxième ($HF_2$) est sélective sur le plan de la fréquence de telle sorte qu'elle agisse pour la composante de lactate ($M_2$) comme une impulsion à 90° et pour la composante de lipide ($L_2$) comme une impulsion à 0°, un récepteur de hautes fréquences (6) pour la réception de signaux de résonance magnétique nucléaire survenant respectivement après la troisième impulsion à haute fréquence ($HF_3$), des moyens (17) pour déterminer le spectre et la distribution de la magnétisation nucléaire à partir des signaux de résonance magnétique nucléaire, des agencements de bobines à gradient (3, 5, 7) pour la production de champs magnétiques à gradient et une unité de commande (15) qui est programmée de telle sorte qu'au moins un champ à gradient magnétique ($G_5$, $G_6$) agisse entre les trois impulsions à haute fréquence et l'intégrale temporelle varie sur au moins un de ces champs à gradient en cas de répétition des séquences.

# FIG.1

FIG.2

FIG.3

FIG.4

FIG.5

FIG.6